# EUROPEAN PATENT SPECIFICATION

(11) **EP 1 730 215 B1**
(45) Date of publication and mention of the grant of the patent: **16.08.2017**
(21) Application number: 05716186.1
(22) Date of filing: 17.03.2005
(51) Int. Cl.: C08J 3/00, C08J 3/20, C08J 3/22, C08K 3/02, C08K 3/04, C08L 79/02, H01L 51/30

(54) **A COMPOSITION COMPRISING A CONDUCTIVE POLYMER IN COLLOIDAL FORM AND CARBON**
ZUSAMMENSETZUNG, DIE EIN LEITFÄHIGES POLYMER IN KOLLOIDALER FORM UND KOHLENSTOFF ENTHÄLT
COMPOSITION COMPRENANT UN POLYMERE CONDUCTEUR SOUS FORME COLLOIDALE ET DU CARBONE

(30) Priority: 18.03.2004 DE 102004013634; 19.03.2004 DE 102004014021; 29.04.2004 US 566954 P
(43) Date of publication of application: 13.12.2006
(73) Proprietor: Enthone GmbH, 40764 Langenfeld (DE); Nissan Chemical Industries, Ltd., Chiyoda-ku, Tokyo 101-0054 (JP)
(72) Inventor: WESSLING, Bernhard, 22941 Bargteheide (DE); FURUSHO, Hitoshi, Funabashi-shi, Chiba 274-8507 (JP); Mitsunobu MATSUMURA, JP/Tokyo 101-0054 (JP); ISAJI, Tadayuki, Funabashi-shi, Chiba 274-8507 (JP)
(74) Representative: Uexküll & Stolberg
(86) International application number: PCT/EP2005/002889
(87) International publication number: WO 2005/090446

(56) References cited:
- WO-A-89/02155
- WO-A-02/074534
- WO-A-2004/029128
- WO-A-2004/029133
- US-A- 4 959 180
- US-A1- 2004 021 131
- KIEBOOMS R ET AL: "SYNTHESIS, ELECTRICAL, AND OPTICAL PROPERTIES OF CONJUGATED POLYMERS" HANDBOOK OF ADVANCED ELECTRONIC AND PHOTONIC MATERIALS AND DEVICES, vol. 8, 2001, pages 1-102, XP001029240
- P.NOVAK, K.MÜLLER, K.S.V.SANTHANAM, O.HAAS: "Electrochemically active polymers for rechargeable batteries" CHEMICAL REVIEWS, vol. 97, 1997, pages 207-281, XP002330853

## Description

### [Technical Field to which the Invention Pertains]

The present invention relates to conductive materials comprising (intrinsically) conductive polymers and carbon black, methods for their manufacture and use for high-capacity electrical double layer capacitors to be utilized in various electronic apparatuses, power supplies and the like.

### [Prior Art]

Conductive Materials are known and used in many different forms and applications. Conductive materials based on carbon are available in several different physical and chemical morphologies, forms and compositions. Pure or mainly pure carbon is available in the form of carbon black (which contains also mainly oxygen based impurities, graphite (pure C), carbon nanotubes and fullerenes and the like. Another
group of conductive materials are (intrinsically) conductive polymers which have found some first applications.

These two groups of conductive materials have at least one property in common, the conductivity. Other properties may be exclusive to the one or the other group of materials, or may vary widely within the respective group. For example, the particle size of graphite is in the range of several to several tens of microns, while that of fullerenes is in the range of angstroms. The specific surfaces of carbon black and carbon nantotubes exhibit high values up to about 1000 m²/g while that of graphite is in the range of a few m²/g. Polyaniline, one of the representatives of conductive polymers, is characterized by a rich redox chemistry, PEDOT (polyethylenedioxythiophene), also termed PEDT, has a moderately or poorly reproducible redox chemistry, while graphite or carbon black show no reversible redox chemistry.

The combination of conductive polymers like polyaniline, polyethylenedioxythiophene, polypyrroles or their derivatives with carbonaceous materials (carbon black, graphite, carbon nanotubes and fullerenes) has been tried in the past. While simple mixtures of said materials do not offer any significant or reproducible advantage, and hence did not find any commercial or technological applications, chemical processes for the combination of conductive polymers and carbon black or conductive polymers and carbon nanotubes have been widely studied. For instance, the company Eeonyx has offered carbon black on which surface polyaniline was polymerised as a developmental product in the market ("Eeonomer"), cf. G. Du, A. Epstein, K. Reimer, presentation on the March 1996 Meeting of the American Physical Society, Session M23, presentation M 23.09. The laboratory chemicals supplier Aldrich has advertised such a chemically produced mixture in their catalogue. However, such a product did not offer interesting advantages.

One of the areas in which carbon black/polyaniline mixtures could offer an interesting technological advantage, could be the area of so the called 'supercapacitors', also often called 'double layer' or 'redox capacitors'. This area provides the highest number of publications in which carbon and conductive polymers have been mixed or provided in form of a mixture.

For this purpose, principally two mixing procedures have been used:
- Simple mixing of powders of carbon black and polyaniline by one day of ball milling (US-Patent Application Publication No. 2002/0114128), or in other ways as disclosed in Journal of Power Sources 11, 2003, 185-190, and Journal of the Electrochemical Society, 148, 10, 2001, A1130-A1134, where a polyaniline or polythiophene derivative was mixed with carbon black powders. However, the specific means of mixing are not disclosed.
- Chemical or electrochemical polymerisation of different conductive polymers on the carbon black surface.

The latter method has been widely investigated in the patent and scientific literature. European Patent Application EP 1 329 918 reports about a negative electrode composite of carbon and polyaniline or polypyrrole in which the conductive polymer was electrochemically polymerised. The positive electrode was made from lead. The conductive polymer content was found to be optimal at 10-15% by weight. The capacitor made by using this material comprised an electrode combination including a positive non-polarisable and a negative polarizable electrode where the positive non-polarisable electrode was made from lead.

US Patent Application 2002/0089807 discloses an intrinsically conductive polymer directly polymerised on highly porous carbon black material by chemical or electrochemical means. The electrochemical polymerisation of polyaniline on a carbon aerogel generated from polyacrylonitrile is disclosed in Journal of Applied Electrochemistry 33, 465-473, 2003. That process is comparable to the electrochemical polymerisation of polyaniline on active porous carbon disclosed in Journal of Power Sources 117, 273-282, 2003 and lit. 10, Carbon 41, 2865-2871, 2003. In Conference Proceedings of ANTEC '98, Vol. 2, 1197ff, 1998, the authors report the polymerisation of polyethylenedioxythiophene on high surface area films of carbon on a platinum current collector support. In the same publication it was reported that polyaniline was cast from hexafluoro-isopropanol solutions on the same type of carbon films.

Electrochimica Acta Vol. 41, No. 1, 21-26, 1996 discloses various redox supercapacitors in symmetry or non-symmetric electrode configuration form in which various conductive polymers like polypyrrole or polythiophene derivatives have been used and polymerised on the substrate, in a comparable procedure as used in US-Patent 5,527,640, 1996, where polythiophene derivatives were polymerised on carbon substrates by electrochemical means.

As explained above, carbon black / conductive polymer mixtures have often been prepared for use in so-called "supercapacitors". Such capacitors are also often referred to as "double layer capacitors", "electrochemical" or "electrical couble layer capacitors" or "redox capacitors" as well as sometimes "pseudo-capacity capacitors".

Conventionally, a double layer capacitor is an energy device in which two electrodes - at least one of which being obtained by coating a collector plate with a porous carbonaceous material having a high specific surface area between and above about 100 and 1000 m²/g to a collector plate - are disposed opposite to each other with a separator disposed therebetween. A voltage is impressed on the electrodes in the presence of an electrolyte solution, to generate an electrical double layer on at least one of the electrodes, and energy can be taken out therefrom. The structure of one kind of double layer capacitor using porous carbonaceous material as electrode material is, as disclosed in the specification and drawings of US Patent No. 5,150,283, classified into a type in which a pair of electrical double layer electrodes (each comprising a polarizable electrode joined to a collector plate) are wound and contained in a container, and a button type in which a pair of electrical double layer electrodes are laminated.

The wound type has a configuration in which a lead wire for giving off energy to the exterior is attached to a collector plate composed, for example, of an etched aluminum foil with a thickness of 20 to 50 µm. The aluminum foil is coated with a paste composed of a powdered mixture prepared by admixing an active carbon powder with a desired binder and a desired conductive agent to form a conductive layer. A polarizable electrode composed of an active carbon layer consisting mainly of active carbon is formed on the conductive layer to obtain an electrical double layer electrode, and a pair of such electrical double layer electrodes is disposed opposite to each other with a separator disposed therebetween and is wound.

Alternatively, the electrical double layer electrodes are assembled by a method in which the polarizable electrode composed of the active carbon layers and the separator are sufficiently impregnated with an electrolytic solution containing an electrolyte dissolved therein under vacuum. The electrodes and the separator are inserted into a case made of aluminum or the like, and an opening portion of the aluminum case is sealed by use of a packing. Generally, this assembly is of a cylinder type.

On the other hand, the button type has a structure in which a polarizable electrode composed of an active carbon layer is formed on a disk-shaped sheet of a valve metal to obtain an electrical double layer electrode. A pair of such electrical double layer electrodes is disposed opposite to each other with an insulating separator therebetween, and this assembly is housed in a metallic container composed of two members. The two electrical double layer electrodes have their disk-shaped form sheets (or foils) of valve metal joined respectively to the inner sides of a bottom portion and a top cover portion of the metallic container, the bottom portion and the top cover portion are joined to each other while being hermetically sealed with an insulating ring packing at a circumferential edge portion thereof, and the inside of the container is filled with a nonaqueous electrolytic solution which is supplied sufficiently to the electrical double layer electrodes and the separator. As the nonaqueous electrolytic solution, for example, a solution prepared by adding tetraethylammonium tetrafluoroborate to propylene carbonate is utilized.

There are several other configurations of double layer capacitors or redox capacitors (often called "supercapacitors") in use which will not be described here in detail.

There has been proposed a high-capacity electrochemical capacitor in which electrochemically active inorganic substances or organic (intrinsically) conductive polymers are used as electrode materials in combination with or in place of the above-mentioned porous carbonaceous material and in which electric power storage based on the formation of electrical double layers is utilized, in the same manner as in the ordinary electrical double layer capacitor using the above-mentioned porous carbonaceous material, and, simultaneously, electric power storage based on an oxidation-reduction potential attendant on oxidation-reduction reactions at both electrodes is utilized, to thereby achieve a high capacity.

For example, an electrochemical capacitor using ruthenium oxide as an electrode active substance (Physics Letters, 26A, p.209 (1968)) is evaluated to be the highest in performance of the electrochemical capacitors using an inorganic oxide known at present, and has been confirmed to have an energy density of 8.3 Wh/kg and an output density of 30 kW/kg.

In recent years, capacitors using other inorganic oxide mixture systems as electrode material have been investigated (J. Power Sources, vol. 29, p.355 (1990)).

Also, electrochemical capacitors using as electrode material (intrinsically) conductive polymers utilizing the oxidation-reduction characteristic of a π-conjugated system organic substance, other than the above-mentioned inorganic metal oxides, have been actively studied in recent years.

The electrochemical capacitors using the conductive polymers have been investigated in many researchinstitutes, and, as to the characteristics, it has been reported that, for example, the use of polypyrrole as electrode material gives a capacity of.86 C/g and an energy density of 11 Wh/kg, the use of a mixture of polypyrrole and polythiophene gives a capacity of 120 C/g and an energy density of 27 Wh/kg, and the use of poly-3- (4-fluorophenyl)thiophene gives a capacity of 52 C/g and an energy density of 39 Wh/kg (J. Power Sources, vol. 47, p.89 (1994)).

Other than the above, in the type of utilizing intercalation for a high-capacity capacitor, generally, a layer structure substance (TiS₂, MoS₂, CoO₂, V₆O₁₃) is used as the electrode material. In this case, the device is in many cases assembled with asymmetric electrodes (Japanese Translations of PCT for Patent Nos. 2002-525864, 2002-542582).

Furthermore, composite materials prepared from the above-mentioned various electrode materials have been evaluated in some cases, to achieve much higher capacities, as compared to the conventional capacitors using only the porous carbonaceous material as an electrode material.

US/2004/0021131 A1 relates to printing of films of electrically conductive organic polymers with additives to enhance the adhesion and resolution of the printed film while retaining adequate electrical conductivity. The additives used are acid plasticizers. Optionally, the compositions may further comprise a certain amount of highly acicular conductors such as carbon nanotubes in order to achieve improved conductivity.

WO 02/074534 A relates to multi-layer films or sheets for packaging applications requiring a thermoplastic material that can dissipate an electrostatic charge. The core layer of the multi-layer structure is a conductive material and may constitute conductive filler like carbon black powders and carbon fibers blended with a nonconductive matrix polymer.

WO89/02155 describes intrinsically conductive polymers in the form of a dispersible solid of primary particles with a specific surface area according to BET of > 15 m²/g and with an average diameter of less than 500 nm, in which preferably not more than 20% of aggregates with an average size > 1µm are present in the particle size range > 500 nm.

US 4959180 A describes processable electrically conductive latex polymer compositions including colloidal particles of an oxidized, polymerized amino-substituted aromatic monomer, a stabilizing effective amount of a random copolymer containing amino-benzene type moieties as side chain constituents and dopant anions.

WO2004/029133 and WO 2004/029128 relate to films cast from compositions comprising aqueous dispersions of polyaniline and colloid-forming polymeric acids in combination with carbon nanotubes in applications such as drain, source, or gate electrodes in thin film field effect transistors.

### [Problems to be Solved by the Invention]

In spite of intensive research, no mixtures of carbon black and (intrinsically) conductive polymers are in industrial use. The reasons for this can mainly be found in a poor homogeneity of the mixture on the nanoscopic scale and a poor reproducibility of the properties due to the manufacturing processes (as described above) used.

On the other hand, the above-mentioned conventional electrical double layer capacitors using a porous carbonaceous material for polarizable electrodes are limited in capacity, though they are good in quick charge-discharge characteristics. For example, as described in Japanese Patent Laid-open No. 2003-338437, a capacitor
using active carbon (surface area: 650 m²/g) obtained by activation of a porous carbonaceous material has an electrostatic capacity of 18.3 F/g, which is lower than those of electrochemical capacitors.

As for the relationship between the electrostatic capacity and the specific surface area of the porous carbonaceous material, an electrostatic capacity of about 22 F/cc is obtained when the specific surface area is in the range of 1500 to 2600 m²/g, but, when the specific surface area is more than the range, the capacity is not increased any longer but tends to the decreased ("Electrical Double Layer Capacitors and Electric Power Storage Systems", The Nikkan Kogyo Shimbun, Ltd., p.9).

Other than the above, further examples of an electrode material using a porous carbonaceous material are disclosed in Japanese Patent Laid-open Nos. 2003-217982, 2003-81624, 2002-373835, and the like, but each of the examples gives a lower capacity, as compared to those of electrochemical capacitors, which matters particularly in use for automobiles and the like.

Besides, when using only the porous carbonaceous material for electrodes, it is necessary to add acetylene black or the like to the binder for the purpose of enhancing conductivity, but, even with such an addition, the interface resistance is very high, which constitutes a serious problem.

On the other hand, there are electrochemical capacitors using a conductive metal oxide as described above. Although such electrochemical capacitors have very high capacities as compared to the cases of using the above-mentioned porous carbonaceous material, the electrochemical capacitors are disadvantageous on the basis of production cost, since the metal of the metal oxide generally belongs to noble metals. For example, pseudo-capacity capacitors using a thin film of ruthenium oxide or indium oxide as electrode material have been reported to have an electrostatic capacity of 160 F/cc in an aqueous system, in the 5th International Seminar on Double Layer Capacitors and Similar Energy Storage Device held in Florida, USA, in 1995.

Besides, the electrochemical capacitors using a conductive polymer material as electrode material generally show a much higher capacity, as compared with those of capacitors using the above-mentioned porous carbonaceous material, but their characteristics may vary depending on the method of forming the electrodes. For example, where the conductive polymer is deposited on collector plates by an electrolytic polymerization method as described in Japanese Patent Laid-open Nos. Hei 6-104141 and Hei 6-104142, the capacitor has a capacity of 3.7 F and an internal resistance of 13.9 Ω, and the formation of electrodes by the electrolytic polymerization method generally involves a serious problem as to productivity thereof.

Therefore, many proposals have been made to use combinations of carbonaceous materials (mainly carbon black) and intrinsically conductive polymers. As described above, only two methods have been used to prepare such mixtures - a dry blending method of powders (by ball milling and the like) and the polymerisation of the conductive polymer in presence of the carbon black.

The method of synthesizing a conductive polymer by chemical oxidation polymerization and preparing a composite material from the conductive polymer and other conductive inorganic material is an apparently relatively simple technology for forming electrodes, and many examples of this technology have been made publicly available in recent years. However, its reproducibility is poor and therefore, no such mixtures are in practical use. Also, the problems to be overcome when trying to scale up and develop a reproducible process are huge.

For example, Japanese Patent Laid-open No. 2002-265598 discloses the use of a composite material of an organic conductive oligomer and an inorganic material as electrode material. In this case, however, the organic conductive oligomer cannot be expected to have a high conductivity, so that the inorganic material is required to have a very high conductivity in order to lower the internal resistance.

Besides, as a similar case of using a conductive polymer material, a method of polymerizing the conductive polymer in a porous carbonaceous material (Japanese Patent Laid-open No. 2001-210557) cannot produce a conductive polymer with a high conductivity but leads to an increase in the internal resistance of the capacitor.

As has been described above, there have hitherto been known a large number of examples of a capacitor using an electrochemically active conductive polymer or inorganic oxide. However, the use of the inorganic material leads to a problem as to production cost, whereas the use of the conductive polymer involves difficulties in control of conductivity, control of particle size and reproducibility, resulting in that the capacitors cannot show sufficient performance.

It was therefore the object of this invention to create a carbon black / conductive polymer mixture which can be manufactured in a reproducible manner and shows superior performance values especially for the manufacture of supercapacitors.

### [Detailed description of the invention]

Most surprisingly, a mixture of (intrinsically) conductive polymer(s) with carbon materials like carbon black, graphite, carbon nanotubes or fullerenes, can reproducibly be manufactured, if the conductive polymer(s) is (are) provided in colloidal form and the colloidal form of the conductive polymer is mixed with the carbon material.

Thus, in a first aspect, the present invention relates to the compositions of claim 1.

In a second aspect, the present invention relates to the method of claim 10.

In a third aspect, the present invention relates to the composite material of claim 13.

In a fourth aspect, the present invention relates to the electrical or electronic article of claim 15.

Preferred embodiments of the present invention are disclosed in the dependent claims.

Carbon black may also comprise other elements such as hydrogen, oxygen, nitrogen and sulphur. For example, carbon black may contain 0.3-1.3 % H, 0.1-0.7 % N, and 0-0.7 % S. Depending on the mode of manufacture, the oxygen content of carbon black may amount to 0-1.5 % for furnace and thermal type carbon blacks, up to 5 % for gas and channel type carbon blacks, and up to 15 % for carbon black post-treated with oxygen. Further, condensed aromatics may be present at the surfaces of the material.

The term "(intrinsically) conductive polymers" (ICP) refers to organic polymers which have (poly)-conjugated π-electron systems (e. g. double bonds, aromatic or heteroaromatic rings or triple bonds). They can exist in various states, each described by different empirical formulae, which can generally be converted essentially reversibly into one another by (electro) chemical reactions such as oxidation, reduction, acid/alkali reaction or complexing. These reactions are also occasionally known as "doping" or "compensation" in the literature, or can be regarded as "charging" and "discharging" in analogy with the electrochemical processes in batteries. At least one of the possible states is a very good conductor of electricity, e. g. has a conductivity of more than 1 S/cm (in pure form), so one can speak of
intrinsically conductive polymers. These forms of the ICP are generally regarded, as poly-radical cationic or anionic salts. A good overview of the (intrinsically) conductive polymers synthesised to date with a chemical structure suitable for the present objective, can be found in Synthetic Metals, Issues 17, 18 and 19 (1987), and in Synthetic Metals (in press), Proceedings of the ICSM ' 88 (Santa Fé).

The chemical nature of the conductive polymers of the invention is not particularly limited, and examples thereof include polyaniline, polyaniline derivatives, polythiophene, polythiophene derivatives, polypyrrole, polypyrrole derivatives, polythianaphthene, polythianaphthane derivatives, polyparaphenylene, polyparaphenylene derivatives, polyacetylene, polyacetylene derivatives, polydiacethylene, polydiacetylene derivatives, polyparaphenylenevinylene, polyparaphenylenevinylene derivatives, polynaphthalene, and polynaphthalene derivatives, polyisothianaphthene (PITN), polyheteroarylenvinylene (ParV), in which the heteroarylene group can be e.g. thiophene, furan or pyrrol, polyphenylene-sulphide (PPS), polyperinaphthalene (PPN), polyphthalocyanine (PPhc) etc., and their derivatives (formed for example from monomers substituted with side chains or groups), their copolymers and their physical compounds. The method for polymerizing the conductive polymers is not particularly limited, and the usable methods include electrolytic oxidation polymerization, chemical oxidation polymerization, and catalytic polymerization. The polymer obtained by the polymerizing method as mentioned is neutral and is not conductive per se. Therefore, the polymer is subjected to p-doping or n-doping to be transformed into a conductive polymer. The substance used for the doping is not particularly limited; generally, a substance capable of accepting an electron pair, such as a Lewis acid, is used. Examples include hydrochloric acid, sulfuric acid, organic sulfonic acid derivatives such as parasulfonic acid, polystyrenesulfonic acid, alkylbenzenesulfonic acid, camphorsulfonic acid, alkylsulfonic acid, sulfosalycilic acid, etc., ferric chloride, copper chloride, and iron sulfate.

It is not critical in the practice of the present invention in which form the carbon black material is provided. The colloidal form of the conductive polymer can be mixed with the carbon black provided in (dry or wet) powder form, in form of a porous film or composite or also in form of a colloidal formulation. The carbon black can be pretreated (e.g. by ball milling), predispersed in water, organic solvent or another medium or shaped in form of fibres, nanofibres, films or porous shapes or membranes. The colloidal form of the conductive polymer may be added to the carbon black or vice versa.

For instance, the carbon black can be added to a colloidal dispersion of the conductive polymer. Alternatively, the conductive polymer dispersion can be added to the carbon black by coating a carbon black substrate with the colloidal dispersion of the conductive polymer.

The colloidal form of the conductive polymer can be manufactured in various different ways which are basically known and state of the art. See for example EP-A- 0 329 768 and German patent application No. 10 2004 003 784. According to the present invention, polymer particles having a size of smaller than 500 mm are considered to be colloidal. The size of the particles can be determined by scanning or transmission electron miscroscopy, or by using laser Doppler technology. Another method of manufacture of the polymer is its polymerisation in the presence of surface active agents so that the resulting polymer remains in colloidal form in the reaction medium. For the subsequent use as colloidal dispersion, one would purify the dispersion by ion exchange and / or membrane filtration.

Alternative methods are procedures by which the conductive polymer is polymerised, then neutralised (compensated) to the non-conductive form and mixed with solvents resulting in a fine colloidal dispersion (often considered to be a "solution"). This colloidal dispersion of the non-conductive form of the conductive polymer can be mixed with the carbon black and the resulting mixture can be rendered
conductive by adding appropriate materials ("dopants") like Broenstedt acids, Lewis acids or oxidants (like iodine, FeCl₃ or else).

Another preferred way is to polymerise the conductive polymer so that it precipitates from the reaction medium, can be filtered, washed and afterwards dispersed. This manner of polymerisation is described in EP-B-0 329 768. Polymers obtained by that process are commercially available from Ormecon GmbH, Germany. See in particular Example 1 and the description at page 8, lines 7-22 of EP-B-0 329 768.

The most preferred way is to use conductive polymer dispersions manufactured as described in German patent application No. 10 2004 003 784, filed January 23, 2004. See in particular claim 6 and Examples 1 to 8 therein. The process of German patent application No. 10 2004 003 784 allows one to prepare colloidal conductive polymers having a conductivity of above 100 S/cm which is advantageous for many applications. In the process, the conductive polymer is in general first polymerized according to the polymerization method of EP-B-0 329 768 so that the primary particles have a diameter of less than 500 nm, and the resulting powder is dispersible. According to one embodiment, this powder is then dispersed in a first dispersion step followed by a conditioning step and a second dispersion step. Finally, the dispersion is formulated so that the colloidal dispersion meets the various following processing and applications requirements (viscosity, stability, drying time and temperature, and others). Suitable dispersion techniques are described in German patent application No. 10 2004 003 784 and include, for example, the use of an ordinary ball mill, a planetary ballmill, a homogenizer, or an ultrasonic dispersing apparatus.

The conductive polymer can be mixed with the carbon black after the second dispersion step (which usually results in a highly viscous paste form) or after the final formulation step (which usually results in a less viscous liquid).

The carbon black tends to agglomerate and is usually not easily impregnated with liquids or colloidal dispersions.

Because it is advantageous for the later use of the carbon black/ conductive polymer mixtures, the surface of the carbon black should be accessible for the colloidal conductive polymer. Therefore it is preferred, to provide the carbon black in form of highly porous structures, fine powders or colloidal dispersions. If dry powders are used, it is preferred to pretreat these powders, e.g. by ball milling. Ball milling can be carried out in planetary mills or satellite ball mills.

The carbon based materials can also be dispersed in presence of the colloidal dispersion of the conductive polymer, e.g. in ball mills.

It is also preferred to manufacture a dispersion of the carbon black in water or organic solvents (with or without using surface active agents, tensides and other materials). Such a dispersion can be made in ball mills, pearl mills, ultrasonic dispersion apparatuses, 2- or 3-roll mills or other state-of-the-art dispersion machines.

In order to attain a highly dispersed state, the dispersing process can be carried out by use of an ordinary ball mill, a planetary ball mill, a homogenizer, or an ultrasonic dispersing apparatus. Where the planetary ball mill is used, stirring is preferably carried out for at least 30 min. Stirring for a long time may be associated with processing problems such as a rise in the temperature of the solvent. Therefore, cooling is needed in the case of stirring for more than 1 hour.

It is preferred to produce a paste of the carbon black which can be mixed with the conductive polymer colloid without, before, during or after further dilution and formulation.

The relation between carbon and conductive polymer may widely vary. For example, the weight ratio of the conductive polymer to carbon may range from 1 : 50 to 50 : 1 or 1: 50 to 50:2.

The final mixture of carbon black and conductive polymer may contain additives like surface active agents or stabilisers, and other materials.

The selection of the carbon black material to be combined with the colloidal conductive polymer is only limited by availability, price and suitability for the final application. Mixtures of different carbon black materials, like active carbon black and conductive carbon black may be advantageous in certain applications.

The same applies to the conductive polymer. Although it is not critical to the process or application requirements of this invention, availability and price may limit the selection of conductive polymers. Generally, all of the above described conductive polymers are useful in the practice of the present invention. Preferred are polyanilines and polythiophenes and their derivatives, in particular polyaniline and its copolymers and derivatives.

Carbon black / conductive polymers according to this invention can be used in conductors, energy stores, sensors, switches, condensers, capacitors and supercapacitors, double layer capacitors and redox capacitors

For the application of carbon black / conductive polymers according to this invention for the storage of (electrical) energy, e. g. in capacitors, active carbon black and polyanilines or polythiophenes and their derivatives are preferred. Conductive carbon black may be used as an additional component as well.

A preferred application of the compositions according to the invention is their use as electrode material in high-capacity capacitors. Such capacitors are often called "super-capacitors" or "double layer capacitor" ("DLC"), also sometimes (referring to some specific mechanism in certain forms of such capacitors) "redox capacitors" In the following, this application will be referred to as "DLC".

One preferred embodiment of the invention is the manufacturing of materials for electrodes for a high-capacity capacitor comprising a porous carbon black material or a valve metal, at least one of the electrodes being formed from a composition containing an electrochemically active substance. Surprisingly, by combining the carbon black with the conductive polymer in colloidal form, it is possible to strongly bind the porous carbon black and to form a stable electrode or electrodes. While in the prior art a non-conductive organic binder has been used as a binder for binding the porous carbon black, the conductive material according to the invention makes it possible to form the electrode without using a binder. In addition, the adhesive force for adhesion to a collector plate can be sufficiently secured by controlling the particle diameter. Moreover, the performance data indicate the superior formation of an electrical double layer, and the material according to the invention can easily impregnated with the electrolyte solution.

Although it is not critical for the scope of this invention, usually, for the use as electrode material, the mixture contains a higher amount of (active) carbon black than conductive polymer.

The conductivity of the conductive polymer contributes particularly to a reduction in the equivalent series resistance of the capacitors. While it is a general practice to add acetylene black or the like as a conductivity-imparting material in the case of an electrode for a capacitor which uses a porous carbonaceous material, the material according to the invention is characterized in that, by providing a conductive polymer with conductivity of I00 S/cm or more, the conductive polymer by itself has the function as a conductivity-imparting material, making it unnecessary to especially add a conductivity-imparting material. Since it is unnecessary to add a conductivity-imparting material, it is possible to enlarge the capacity of the actual product. In this case, the conductivity of the conductive polymer is at least 100 S/cm, preferably 200

S/cm or more, and" more particularly 500 S/cm or more. The conductivity is preferably as high as possible, since it has a great influence on the internal resistance of the capacitor to be made.

In a further embodiment of the invention, the conductive polymer is dispersed in water or an organic solvent. Particularly, the composition specified conditionally can be used separately for the case where the electrolyte in the capacitor is Water and for the case where the electrolyte is an organic solvent. Especially where the electrolytic liquid is water, the use of the conductive polymer dispersed in an organic solvent is advantageous to the stability of the electrode.

In another embodiment of the invention, an electrode composition for a capacitor is provided, wherein the conductive polymer dispersion element contains solid components in a concentration of not more than 20 wt%. Particularly at the time of forming the electrodes, the concentration of the solid components greatly influences the productivity and cost. However, the solid components in the conductive polymer dispersion element influences the stability of the dispersion, too. Therefore, the concentration of the solid components is not more than 20 wt% where production cost is taken into account, and the concentration is not more than 10 wt%, preferably not more than 5 wt%, where the stability of the dispersion is also taken into account.

In still another embodiment of the invention, it is preferred to focus on the specific surface area of the porous carbon black. A sufficient capacity of the DLC can be obtained by use of a carbon black with a specific surface area of not less than 100 m²/g, preferably 500 m²/g, more preferably 1000 m²/g. Such a porous carbon black is dispersed in the conductive polymer dispersion element.

The amount of the porous carbon black used can widely vary. It is necessary to add the porous carbon black in an amount of at least 5 wt%, in relation to the weight of solid polyaniline.

The addition amount is closely related to the 'charge-discharge rate of the capacitor. It is desirable to add the porous carbon black in a larger amount in the case of devices for quick charge-discharge, and to add the conductive polymer in a larger amount in the case of devices for slow charge-discharge. Thus, according to the present invention, it suffices to control the addition amount according to the device requirements. In order to obtain a capacitor with a capacity of at least greater than that of a capacitor using solely the porous carbon black, it is necessary to add the conductive polymer in an amount in terms of solid components of not less than 5 wt%. In order to obtain a sufficient oxidation-reduction performance, it is necessary to add the conductive polymer in an amount in terms of solid components of preferably not less than 10 wt%.

In still another embodiment of the invention, the materials are used for electrodes for a DLC, said electrodes being disposed opposite to each other with the separator disposed therebetween, wherein both of the two electrodes are composed of the same kind of conductive polymer. This configuration has the merit of providing a very inexpensive device, in consideration of the productivity thereof.

In still another embodiment of the invention, the materials are used for electrodes for a DLC, wherein the compositions used to form the two electrodes disposed opposite to each other with the separator disposed therebetween comprise different kinds of conductive polymers. This is based on the consideration that many of organic conductive polymers show different activities under a positive voltage and under a negative voltage. In other words, a method of obtaining a high-capacity device resides in using a conductive polymer material which shows the highest electrical activity when the voltage is swept.

In still another embodiment of the invention, the materials are used for electrodes for a DLC, wherein one of the two electrodes comprises a porous carbon black, and the other comprises a porous carbon black /conductive polymer
composite according to the invention. This configuration shows a surprisingly high capacity.

In still another embodiment of the invention, the materials are used for electrodes for a DLC, wherein one of the two electrodes comprises a metal oxide, and the comprises a porous carbon black /conductive polymer mixture according to the invention. This configuration is effective particularly in the case of obtaining a high capacity by utilizing the oxidation'-reduction characteristics of the metal oxide electrode. Particularly desirable examples of the material of the metal oxide electrode are ruthenium oxide and indium oxide.

Moreover, where the inorganic material/conductive polymer composite body in the present invention is formed into a film or other molded product, it is possible to add a stabilizer, a light stabilizer, a filler, a binder, a conductivity-imparting agent and the like, as required.

The effects of using carbon / colloidal conductive polymer mixtures as electrode materials in DLC are quite surprising. Compared with such types of capacitors manufactured by polymerising a conductive polymer in presence or on the surface of (active) carbon black used in DLC, the capacitors manufactured using the mixtures according to this invention exhibit significantly better properties. However, it is noted that the scope of this invention is not limited by the specific properties of the DLC manufactured according to the invention. In other words, DLCs which may show a lower performance are also considered to be within the scope of this invention.

The capacity may range film, for example, over 50 to well over 200 F/g, the power density may range, for example, from about 1,000 to several 1,000 W/kg, and the energy density ranges, for example, from about 10 and well over 100 Wh/kg.

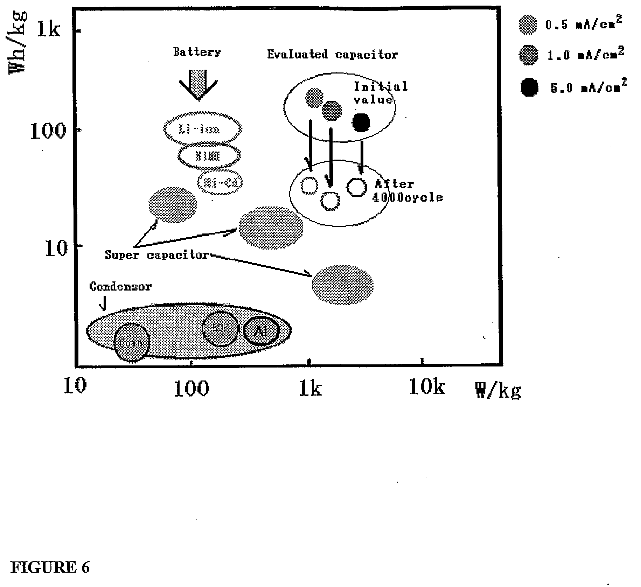

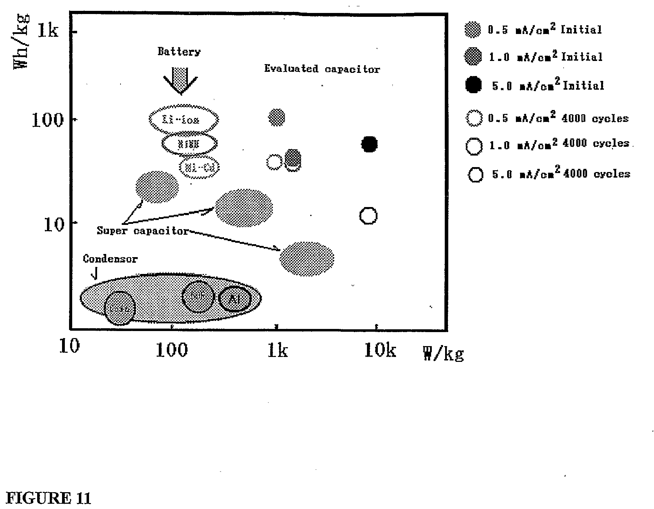

As can be seen in Figure 6 and Figure 11 (Ragon plots), this set of characteristics positions the DLC according to the invention outside of the presently accessible range of power and energy density, significantly higher than DLCs (supercapacitors) and even Lithium ion batteries of the present state of the art.

Some of the reasons for this surprising effect may be - without intending to be limited by this explanation - (a) that there is no need any more for adhesive or film forming additives (in order to form an adhering electrode material layer on the surface of the metallic collector) (b) a lower internal resistance and (c) the additional possibility of redox reactions, all together increasing the accessible surface (accessible for charge carriers and their exchange), the Wetting of the electrolyte on the electrode material and the energy density (charge per weight).

### [Mode for Carrying Out the Invention]

### Examples

### Example 1: Production of Porous carbon black /Conductive Polymer Composite Electrodes

Pulverized coconut shell active carbon (not yet activated) in an amount of 18 g was dispersed in 90.9 g of a conductive polymer dispersion (ORMECON 7301-026-002, a dispersion of conductive polyaniline in xylene; solid components: 2.2%), and the mixture was stirred by a planetary ball mill for 60 min. To the porous carbon black / conductive polymer slurry, 57.3 g of xylene was further added, and the mixture was stirred by a stirring motor for 30 min, to prepare a porous carbon black / conductive polymer dispersion.

Electrodes for a capacitor need collector plates adapted to the electrolytic solution used in the capacitor. In this example, platinum plates were used for electrodes when using aqueous sulfuric acid solution (1 mol/1) as the electrolytic solution, and aluminum was used for the electrodes when using propylene carbonate as the electrolytic solution. Where platinum is used for the collector plates in the actual
electrodes for the capacitor, the surfaces of platinum plates are first scratched with a file, and are then coated with a fixed amount of the porous carbon black /conductive polymer dispersion prepared as decribed above. Then, the coated platinum plates are placed in a high-temperature tank at 100°C for 1 hour to sufficiently remove the organic solvent. The electrodes thus formed were subjected to weighing of the electrode active substance, and were used directly as the electrodes for the capacitor.

When using a 1 mol/1 solution of tetraethylammonium tetrafluoroborate in propylene carbonate as an organic solvent based electrolytic solution, aluminum plates were used as collector plates. The aluminum collector plates were scratched by a file and coated with a fixed amount of the porous carbon black /conductive polymer dispersion, in the same manner as in the case of using the platinum plates as the collector plates. Thereafter, drying was conducted at 100°C for 24 hours, to sufficiently remove moisture.

The components of the dispersion used for forming the porous carbon black / conductive polymer composite electrodes are shown in the following Table 1.

**Table 1**

| | Conductive polymer | Dispersion medium | Specific surface area of active carbon black (m²/g) | Solid component ratio C:ICP |
|---|---|---|---|---|
| Experiment 1 | Polyaniline | Xylene | 1100 | 9:1 |
| Experiment 2 | Polyaniline | Xylene | 1100 | 8:2 |
| Experiment 3 | Polyaniline | Xylene | 1100 | 1:9 |
| Experiment 4 | Polyaniline | Xylene | 1600 | 9:1 |
| Experiment 5 | Polyaniline | Xylene | 1600 | 8:2 |
| Experiment 6 | Polyaniline | Xylene | 1600 | 1:9 |
| Experiment 7 | Polyaniline | Water | 1600 | 8:2 |
| Experiment 8 | PEDOT | Water | 1600 | 8:2 |

### Example 2: Production of Capacitor Cell

Each electrode plate with the electrode active substance in close contact therewith, as prepared in Example, 1 is blanked into circular disks with a diameter of 1 cm, to prepare two electrodes. A glass fiber filter is blanked into a circular shape with a diameter of 1.5 cm and used as a separator. Further, an aqueous 1 M solution of sulfuric acid is used as an electrolytic solution in the case of an aqueous system. A 1 M solution of tetraethylammonium tetrafluoroborate in propylene carbonate is used as an electrolytic solution in the case of an organic solvent system.

### Evaluation of Capacitor Characteristics

Measuring Instruments: The internal resistance of each capacitor cell was measured by use of an impedance analyzer YHP 4192A, available, from Hewlett-Packard Development Company, L.P. Measurements in a charge-discharge test were carried out by use of a TOYO System TOSCAT-3100U, available from TOYO SYSTEM, Co.. LTD.

The results of the charge-discharge test of capacitors using the electrode active substances shown in Experimental Example 1 are shown as Examples in the following Table 2.

**Table 2**

| Test No. | Electrode active substance | Dispersion | Charging rate (mA/cm²) | Charging capacity (F/g) | Discharging rate (mA/cm²) | Discharging capacity (F/g) |
|---|---|---|---|---|---|---|
| 1 | Experiment 1 | Sulfuric acid solution | 10 | 250 | 10 | 250 |
| 2 | Experiment 1 | Sulfuric acid solution | 5 | 240 | 5 | 240 |
| 3 | Experiment 1 | Sulfuric acid solution | 1 | 220 | 1 | 220 |
| 4 | Experiment 2 | Sulfuric acid solution | 10 | 250 | 10 | 250 |
| 5 | Experiment 2 | Sulfuric acid solution | 5 | 220 | 5 | 220 |
| 6 | Experiment 2 | Sulfuric acid solution | 1 | 170 | 1 | 170 |
| 7 | Experiment 2 | TEATFB | 10 | 90 | 10 | 90 |
| 8 | Experiment 2 | TEATFB | 5 | 100 | 5 | 100 |
| 9 | Experiment 2 | TEATFB | 1 | 150 | 1 | 150 |
| 10 | Experiment 4 | TEATFB | 10 | 40 | 10 | 40 |
| 11 | Experiment 4 | TEATFB | 5 | 170 | 5 | 170 |
| 12 | Experiment 4 | TEATFB | 1 | 170 | 1 | 170 |
| 13 | Experiment 5 | TEATFB | 10 | 140 | 10 | 140 |
| 14 | Experiment 5 | TEATFB | 1 | 200 | 1 | 200 |

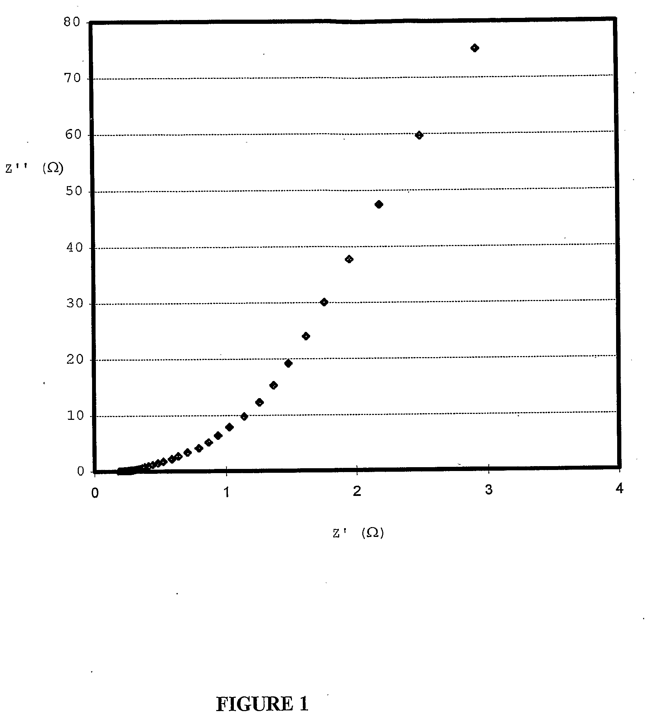

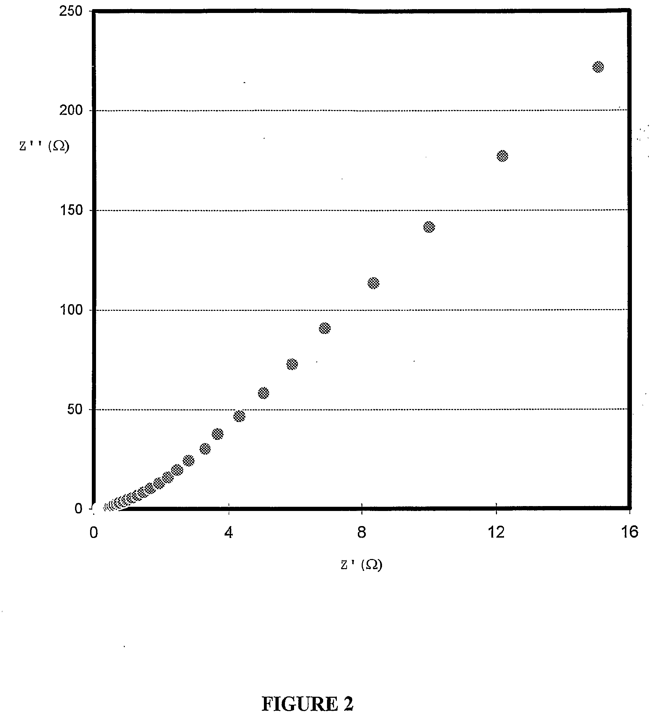

The results of evaluation of internal resistance are shown in Figure 1 and Figure 2. Measurement was conducted by use of a capacitor cell formed by using the electrodes using the dispersion elements of Experiment 2 and Experiment 5, and using a 1 M sulfuric acid solution as the electrolytic solution.

Fig. 1 shows the internal resistance of the capacitor (impedance characteristics) using the porous carbon black with a specific surface area of 1600 m²/g.

Fig. 2 shows the internal resistance of the capacitor (impedance characteristics) using the porous carbon black with a specific surface area of 1100 m²/g.

### Comparative Example

A mixture of an electrode material including 60 wt% activated carbon (specific surface area of about 1600 cm²/g), 30 wt% carbon black, and 10 wt% tetrafluoroethylene as binder was prepared. For film formation methanol was added to this mixture. electrode sheet (10mm width, 10mm length, 3 mm thickness) was
prepared by using a rolling method. This sheet was dried at 250°C at overwise ambient conditions.

Charge-discharge test were then carried out using the same method as described above in Example 2. In this case, the charge capacity was about 4.7 F/g only.

### Example 3

### 1) Agent and apparatus:

BELLFINE AP, which is produced by KABEBO LTD, was used as active carbon material.

D1005W (dispersion of polyaniline in water) and 7201-026-001(dispersion of polyaniline in xylene), both available from Ormecon GmbH, Ammersbek, Germany were used as conductive polymers in colloidal form.

Charge-discharge test was carried out by the use of TOCAT-3100U battery testing unit (TOYO SYSTEM, CO., LTD.). Impedance property was measured using 4192A LF IMPEDANCE ANALYZER (HEWLETT PACKARD).

### 2) Preparation of a mixture of conductive polymer and active carbon:

The mixture was prepared by using the following procedure. 8.0g of the active carbon and 90.9g of ORMECON 7201-026-001(solid :2.20%) were mixed using a Satellite ball mill for 60min. This mixture was used as electrode material. Electrode films were made by applying a 200 µm coating of the material on an aluminum plate. The wet film was dried at 100 °C under ambient conditions.

### Results:

### 1: Composition obtained from organic (xylene) polyaniline dispersion (7201-026-001)

Charge-discharge testing was carried out using the thin film having a mixture of 7201-026-001 and BELLFINE AP. Charge-discharge properties were determined at 0.5mA/cm², 1mA/cm², and 5mA/cm². Initial capacities under these conditions are listed in Table 3.

**Table 3: Initial capacity of ICP based capacitor.**

| Current density (mA/cm²) | Capacity (F/g) | Power density (W/kg) | Energy Density (Wh/kg) |
|---|---|---|---|
| 0.5 | 254.9 | 1090 | 141.6 |
| 1.0 | 237.4 | 1805 | 131.9 |
| 5.0 | 211.3 | 5076 | 117.4 |

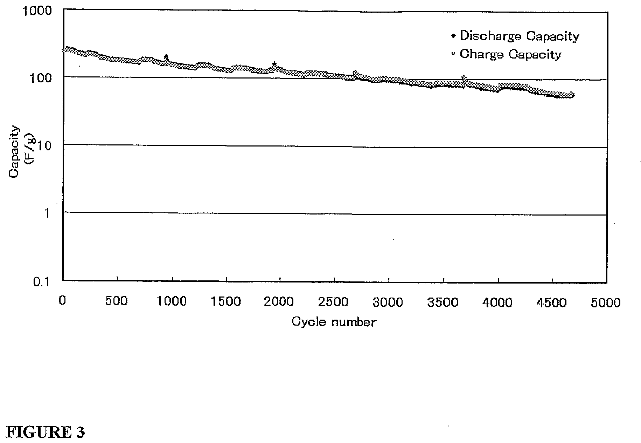

Both power density and energy density were excellent. This capacity is bigger than that of a capacitor made from BELLFINE carbon only. For the 'BELLFINE only' capacitor, the capacity is about only 30 F/g. Results of cycle tests are indicated in Figure 3, Figure 4, and Figure 5.

Fig.3 shows the result of a cycle test of capacitor at a current density of 0.5mA and a voltage of 2.0V using a propylene carbonate electrolyte including 0.01M tetraethylammonium tetrafluoroborate.

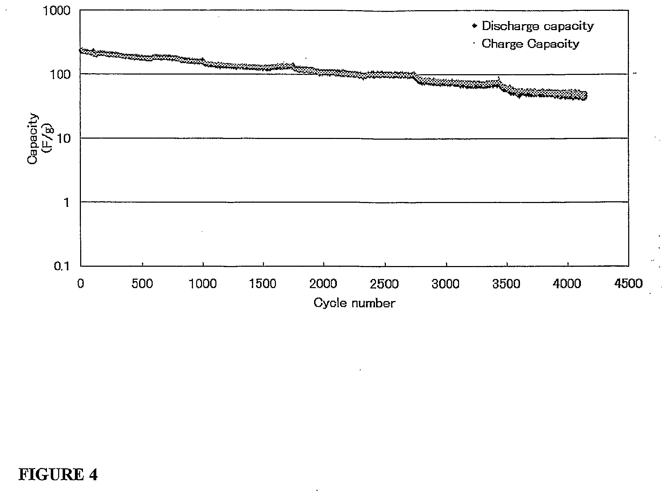

Fig.4 shows the result of a cycle test of capacitor at a current density of 1.0mA and a voltage of 2.0V using a propylene carbonate electrolyte including 0.01M tetraethylammonium tetrafluoroborate.

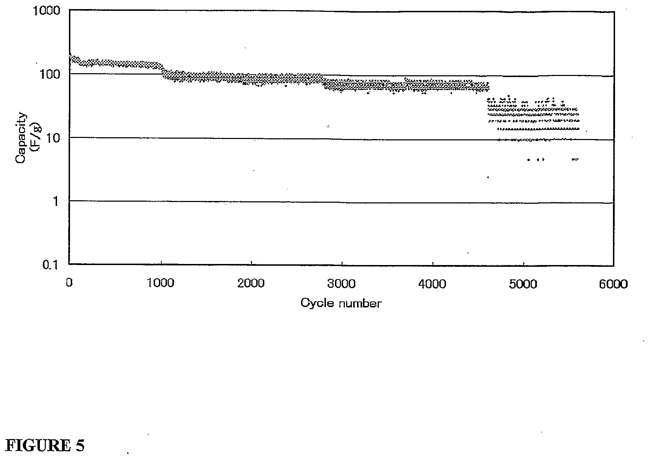

Fig.5 shows the result of a cycle test of capacitor at a current density 5.0mA and a voltage of 2.0V using a propylene carbonate electrolyte including 0.01M tetraethylammonium tetrafluoroborate

After the 4000cycle test, the capacitance decreased to about 1/3 of the initial value. Capacitance after 4000cycles is listed in Table 4.

**Table 4: Capacity of ICP Based Capacitor. After 4000cycles**

| Current density (mA/cm2) | Capacity (F/g) | Power density (W/kg) | Energy density (Wh/kg) |
|---|---|---|---|
| 0.5 | 74 | 1099 | 41.2 |
| 1.0 | 50 | 2051 | 27.9 |
| 5.0 | 73 | 5188 | 41.0 |

A Ragon-plot of this cycle test data is shown in Fig.6. It can be seen that the capacitance of the evaluated capacitor is higher than that of conventional ones. Specifically, energy density decreases with an increasing number of cycles. Clearly, however, power density hardly changes as compared to the initial value. In the case of 5mA/cm² condition, the characteristic got worse quickly after about 4500 cycles.

In order to understand the resistance components, impedance characteristics were measured. Measurement of impedance was carried out in the range from 5Hz to 13MHz The interface action of ion species, however, cannot be seen in this frequency area. First, the resistance icomponent was checked by a Cole-Cole plot. Then change of each resistance was conformed by comparing with the Cole-Cole plot of initial resistance component with that of resistance component after 4000 cycles. In the case of this capacitor, equivalent circuit was depicted as follow;

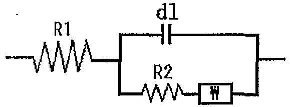

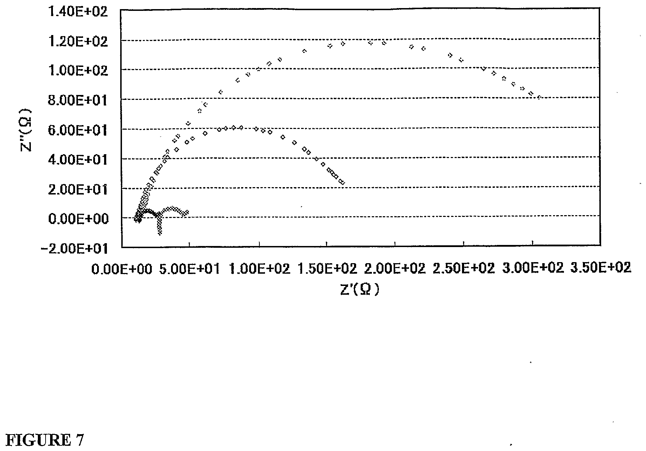

In the case of a capacitor, R1 is a solution resistance which is in series with electrode interfacial impedance, and R2 is the Faradaic resistance of electrode process at reversible potential. This value is influenced by the resistance of conducting polymer. The Cole-Cole plot is shown in Fig.7.

R1 and R2 values are listed in Table 5.

**Table 5: Resistance of capacitor using Conductive polymer and active carbon mixture as electrode.**

| Resistance | 0.5mA/cm2 R1(Ω) | 0.5mA/cm2 R2(Ω) | 5.0mA/cm2 R1(Ω) | 5.0mA/cm2 R2(Ω) |
|---|---|---|---|---|
| Initial | 27 | 18 | 18 | 18 |
| 4000cycle | 18 | 430 | 18 | 200 |

The above data shows that, although R1 did not change with both current density, R2 changed drastically with 4000 cycles. It is assumed that this change was dependent on the change of conductive polymer resistance such as elimination of dopant, oxidation of conductive polymer, decomposion of polymer and so on.

### 2. Water dispersed polyaniline (D1005W)

Charge-discharge test was carried out by the use of thin film on A1 plate, which was made from mixture of D1005W and BELLFINE AP. Charge-discharge tests were performed at 0.5mA/cm², 1mA/cm², and 5mA/cm². Initial capacities under these conditions are listed in Table 6.

**Table 6: Initial capacity of ICP based capacitor.**

| Current density (mA/cm²) | Capacity (F/g) | Power density (W/kg) | Energy Density (Wh/kg) |
|---|---|---|---|
| 0.5 | 185.1 | 1225 | 102.8 |
| 1.0 | 66.07 | 1549 | 36.7 |
| 5.0 | 106.7 | 12769 | 59.3 |

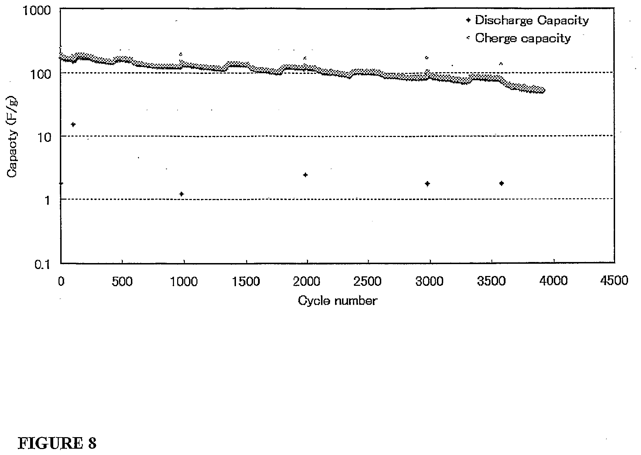

Energy density of capacitor using D1005W was less than that of capacitor using 7201-026-001. Results of Cycle test are shown in Fig.8 , Fig 9, and Fig 10.

Fig. 8 shows the result of a cycle test of capacitor at a current density of 0.5mA and a voltage of 2.0V and using a propylene carbonate electrolyte including 0.01M tetraethylammonium tetrafluoroborate

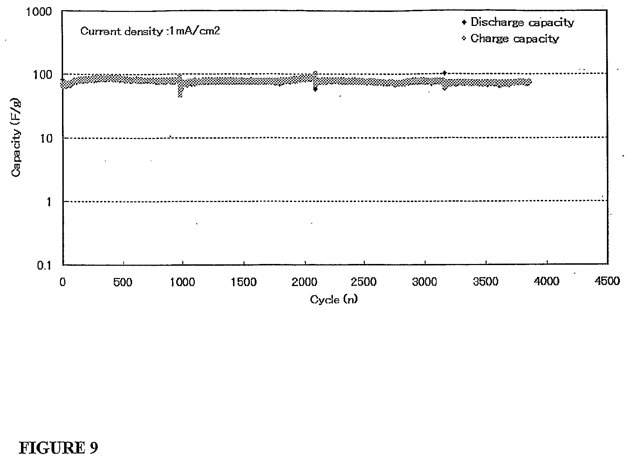

Fig 9 shows the result of a cycle test of capacitor at a current density of 1.0 mA and a voltage of 2.0V and using a propylene carbonate electrolyte including 0.01M tetraethylammonium tetrafluoroborate.

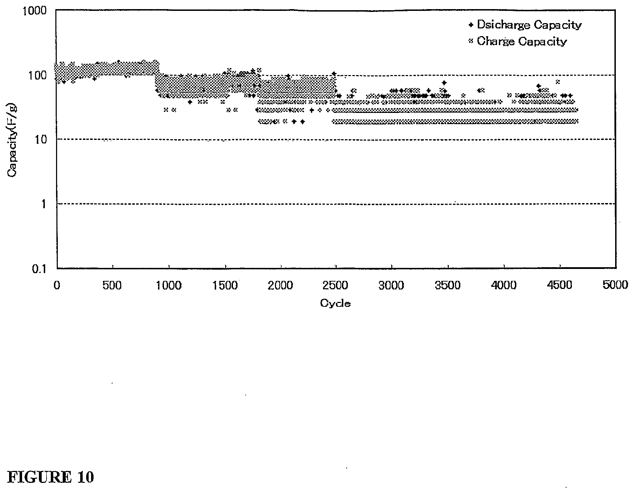

Fig. 10 shows the result of a cycle test of capacitor at a current density of 5.0 mA and a voltage of 2.0V and using a propylene carbonate electrolyte including 0.01M tetraethylammonium tetrafluoroborate.

In the case of 1.0mA/cm2, change of capacitance was not observed in the cycle test. In the case of 5.0mA/cm2, however, a rapid reduction of capacitance was observed at 1000 cycles. The capacity data after 4000 cycles are listed in Table 7.

**Table 7: Capacity of ICP based capacitor of 4000cycles after.**

| Current density (mA/cm²) | Capacity (F/g) | Power density (W/kg) | Energy Density (Wh/kg) |
|---|---|---|---|
| 0.5 | 55.1 | 1233 | 30.6 |
| 1.0 | 63.1 | 1311 | 35.1 |
| 5.0 | 19.4 | 10621 | 10.7 |

A Ragon-plot of the cycle test data are shown in Fig.11.

From the data it is apparent that energy density decreases with an increasing number of cycles. However, power density hardly changes as compared to the initial value. At a current density of 1.0mA/cm², power density and energy density were very stable for about 4000 cycles. At 5.0mA/cm², power density got worse quickly after about 1000 cycles.

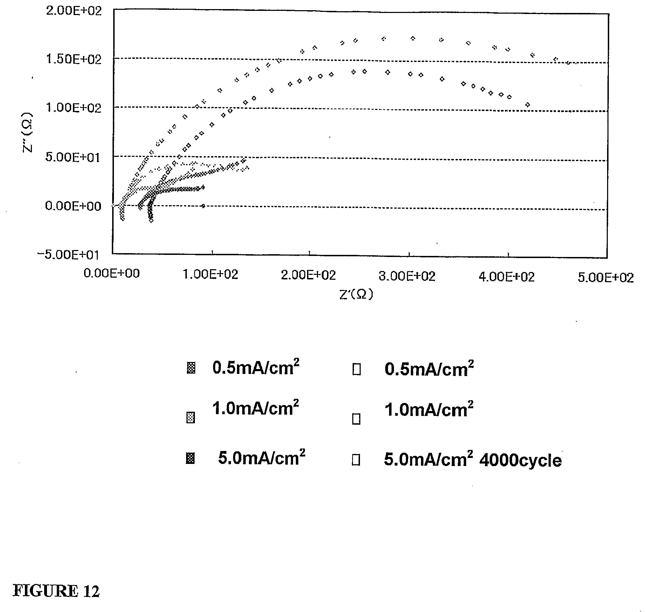

In order to analyse the resistance component, impedance measurements was carried out using impedance analyzer. Results of the impedance measurement are shown in Fig. 12, which is a Cole-Cole Plot of capacitor using mixture of conductive polymer and active carbon as electrode.

R1 and R2 values from the Cole-Cole plot are listed in Table 8.

**Table 8: Resistance of capacitor using Conductive polymer and active carbon mixture as electrode.**

| Resistance | 0.5mA/cm2 R1(Ω) | 0.5mA/cm2 R2(Ω) | 1.0mA/cm2 R1(Ω) | 1.0mA/cm2 R2(Ω) | 5.0mA/cm2 R1(Ω) | 5.0mA/cm2 R2(Ω) |
|---|---|---|---|---|---|---|
| Initial | 27 | 150 | 7.4 | 7.8 | 27 | 37 |
| 4000cycle | 130 | 700 | 65 | 150 | 130 | 520 |

This R2 resistance component is bigger than that of 7201-026-001 based capacitor's R2. Without being bound by theory, it is assumed that the difference of R2 resistance between D1005W based capacitor and 7201-026-001 based capacitor can be attribute to difference of conductivity between D1005W and 7201-026-001. Both of R1 and R2 resistance increased drastically after 4000 cycles.

### [Effects of the Invention]

As has been described above, the present invention provides an electrical double layer capacitor in which a pair of polarizable electrodes each comprising a solid electrolyte of a conductive polymer contained in an active carbon layer are opposed to each other with a separator disposed therebetween. Particularly, by enhancing the particle diameter and conductivity of the conductive polymer, it is possible to obtain an electrical double layer capacitor having a low internal resistance and a high capacity.

## Claims

1. A composition capable of forming a coating and comprising a mixture of a conductive polymer in colloidal form, carbon black, and a liquid dispersion medium, wherein the conductivity of the conductive polymer is greater than 100 S/cm.

2. The composition according to claim 1, wherein the conductive polymer is selected from polymers of anilines, thiophenes, pyrroles and substituted derivatives thereof

3. The composition according to claim 1 or claim 2, wherein two or more different conductive polymers are present.

4. The composition according to any one of the preceding claims, wherein the carbon black has a specific surface area of more than 100 m²/g, as measured according to the BET method.

5. The composition according to claim 1, wherein the carbon black is active carbon black.

6. The composition according to claim 5, wherein the active carbon black has a specific surface of greater than 750 m²/g.

7. The composition according to any one of the preceding claims, wherein the average particle size (number average) of the conductive polymer is smaller than 500 nm.

8. The composition according to any one of the preceding claims, wherein the weight ratio of the conductive polymer to carbon is in the range of from 1 : 50 to 50 : 1.

9. The composition according to any one of the preceding claims, wherein the liquid dispersion medium comprises water and/or organic solvent(s).

10. A method for manufacture of a coating based on a composition according to any one of the preceding claims, comprising dispersing the conductive polymer and carbon, and optionally additives in a liquid dispersion medium and drying the liquid dispersion after application on a substrate.

11. The method of claim 10, wherein the conductive polymer is dispersed in a first liquid and the carbon is dispersed separately in a second liquid, said liquids being the same or different, and the respective dispersions are subsequently mixed together, optional additives being added before, during or after the separate dispersion steps.

12. The method of claim 10, wherein the conductive polymer is dispersed in a liquid and the carbon is separately milled in the absence of liquid, and wherein the dry milled carbon is subsequently added to the liquid colloidal dispersion of the conductive polymer and dispersed therein.

13. A composite material comprising a coating on a substrate, said coating being obtained by the method of any one of claims 10 to 12.

14. The composite material of claim 13, wherein the substrate is selected from the group consisting of metals, semiconductors, plastics, ceramics and wood products.

15. An electrical or electronic article comprising the composite material according to claim 13 or claim 14.

16. The article of claim 15, wherein the article is selected from the group consisting of conductors, energy stores, sensors, switches, condensers, capacitors and supercapacitors, double layer capacitors and redox capacitors.

17. The article of claim 16, said article being a capacitor comprising an electrolyte and a pair of electrodes with a separator disposed therebetween, wherein at least one of the electrodes comprises the composite material according to claim 13 or claim 14.

18. The capacitor of claim 17, wherein both electrodes comprise the composite material according to claim 13 or claim 14.

19. The capacitor of claim 17, wherein one electrode comprises the composite material according to claim 13 or claim 14 and the other electrode is a conventional capacitor electrode.

20. The capacitor of claim 19, wherein the other electrode comprises a current collector coated with a composition containing an intrinsically conductive polymer but no carbon.

## Patentansprüche

1. Zusammensetzung, die zur Bildung einer Beschichtung geeignet ist und eine Mischung aus leitfähigem Polymer in kolloidaler Form, Ruß und flüssigen Dispersionsmittel umfasst, wobei die Leitfähigkeit des leitfähigen Polymers größer als 100 S/cm ist.

2. Zusammensetzung nach Anspruch 1, bei der das leitfähige Polymer aus Polymeren von Anilinen, Thiophenen, Pyrrolen und substituierten Derivaten davon ausgewählt ist.

3. Zusammensetzung nach Anspruch 1 oder Anspruch 2, bei der zwei oder mehrere verschiedene leitfähige Polymere vorhanden sind.

4. Zusammensetzung nach einem der vorhergehenden Ansprüche, bei der der Ruß eine spezifische Oberfläche von mehr als 100 m²/g, wie gemäß des BET Verfahrens gemessen, aufweist.

5. Zusammensetzung nach Anspruch 1, bei der der Ruß Aktivruß ist.

6. Zusammensetzung nach Anspruch 5, bei der der Aktivruß eine spezifische Oberfläche von mehr als 750 m²/g aufweist.

7. Zusammensetzung nach einem der vorhergehenden Ansprüche, bei der die durchschnittliche Teilchengröße (Zahlenmittel) des leitfähigen Polymers kleiner als 500 nm ist.

8. Zusammensetzung nach einem der vorhergehenden Ansprüche, bei der das Gewichtsverhältnis des leitfähigen Polymers zu Kohlenstoff im Bereich von 1 : 50 bis 50 : 1 liegt.

9. Zusammensetzung nach einem der vorhergehenden Ansprüche, bei der das flüssige Dispersionsmittel Wasser und/oder organische(s) Lösungsmittel umfasst.

10. Verfahren zur Herstellung einer Beschichtung, die auf einer Zusammensetzung gemäß einem der vorhergehenden Ansprüche basiert, bei welchem Verfahren das leitfähige Polymer und Kohlenstoff und gegebenenfalls Additive in flüssigem Dispersionsmittel dispergiert werden und die flüssige Dispersion nach Aufbringung auf einem Substrat getrocknet wird.

11. Verfahren nach Anspruch 10, bei dem das leitfähige Polymer in einer ersten Flüssigkeit dispergiert wird und der Kohlenstoff getrennt in einer zweiten Flüssigkeit dispergiert wird, wobei die Flüssigkeiten gleich oder verschieden sind, und die jeweiligen Dispersionen anschließend zusammengemischt werden, wobei fakultative Additive vor, während oder nach den getrennten Dispergierschritten zugegeben werden.

12. Verfahren nach Anspruch 10, bei dem das leitfähige Polymer in einer Flüssigkeit dispergiert wird und der Kohlenstoff getrennt in Abwesenheit von Flüssigkeit gemahlen wird und bei dem der trockene gemahlene Kohlenstoff anschließend der flüssigen kolloidalen Dispersion des leitfähigen Polymers zugegeben und darin dispergiert wird.

13. Verbundmaterial, das eine Beschichtung auf einem Substrat umfasst, welche Beschichtung durch das Verfahren gemäß einem der Ansprüche 10 bis 12 erhalten wird.

14. Verbundmaterial nach Anspruch 13, bei dem das Substrat aus der Gruppe bestehend aus Metallen, Halbleitern, Kunststoffen, Keramiken und Holzprodukten ausgewählt ist.

15. Elektrischer oder elektronischer Artikel, der das Verbundmaterial gemäß Anspruch 13 oder Anspruch 14 umfasst.

16. Artikel nach Anspruch 15, bei dem der Artikel aus der Gruppe bestehend aus Leitern, Energiespeichern, Sensoren, Schaltern, Kondensoren, Kondensatoren und Superkondensatoren, Doppelschichtkondensatoren und Redoxkondensatoren ausgewählt ist.

17. Artikel nach Anspruch 16, bei dem der Artikel ein Kondensator ist, der Elektrolyt und Elektrodenpaar mit dazwischen angeordneten Separator umfasst, wobei mindestens eine der Elektroden das Verbundmaterial gemäß Anspruch 13 oder Anspruch 14 umfasst.

18. Kondensator nach Anspruch 17, bei dem beide Elektroden das Verbundmaterial gemäß Anspruch 13 oder Anspruch 14 umfassen.

19. Kondensator nach Anspruch 17, bei dem eine Elektrode das Verbundmaterial gemäß Anspruch 13 oder Anspruch 14 umfasst und die andere Elektrode eine herkömmliche Kondensatorelektrode ist.

20. Kondensator nach Anspruch 19, bei dem die andere Elektrode einen Stromabnehmer umfasst, der mit einer Zusammensetzung beschichtet ist, die intrinsisch leitfähiges Polymer, aber keinen Kohlenstoff enthält.

## Revendications

1. Composition capable de former un revêtement et comprenant un mélange d'un polymère conducteur sous forme colloïdale, de noir de carbone et d'un milieu de dispersion liquide, dans laquelle la conductivité du polymère conducteur est supérieure à 100 S/cm.

2. Composition selon la revendication 1, dans laquelle le polymère conducteur est sélectionné parmi des polymères à base d'anilines, de thiophènes, de pyrroles et de dérivés substitués de ceux-ci.

3. Composition selon la revendication 1 ou la revendication 2, dans laquelle deux polymères conducteurs différents ou plus sont présents.

4. Composition selon l'une quelconque des revendications précédentes, dans laquelle le noir de carbone a une superficie spécifique telle que mesurée par la méthode BET supérieure à 100 m²/g.

5. Composition selon la revendication 1, dans laquelle le noir de carbone est un noir de carbone activé.

6. Composition selon la revendication 5, dans laquelle le noir de carbone activé a une superficie spécifique supérieure à 750 m²/g.

7. Composition selon l'une quelconque des revendications précédentes, dans laquelle la dimension particulaire moyenne (moyenne en nombre) du polymère conducteur est inférieure à 500 nm.

8. Composition selon l'une quelconque des revendications précédentes, dans laquelle le rapport en poids entre le polymère conducteur et le carbone est dans la plage de 1 : 50 à 50 : 1.

9. Composition selon l'une quelconque des revendications précédentes, dans laquelle le milieu de dispersion liquide comprend de l'eau et/ou un ou des solvant(s) organique(s).

10. Procédé de fabrication d'un revêtement basé sur une composition selon l'une quelconque des revendications précédentes, qui comprend la dispersion du polymère conducteur et du carbone, et en option d'additifs, dans un milieu de dispersion liquide et le séchage de la dispersion liquide après l'application sur un substrat.

11. Procédé de la revendication 10, dans lequel le polymère conducteur est dispersé dans un premier liquide et le carbone est dispersé séparément dans un deuxième liquide, lesdits liquides étant identiques ou différents, et les dispersions respectives étant ensuite mélangées ensemble, des additifs étant en option ajoutés avant, pendant ou après les étapes de dispersion séparées.

12. Procédé de la revendication 10, dans lequel le polymère conducteur est dispersé dans un liquide et le carbone est broyé séparément en l'absence de liquide et dans lequel le carbone broyé sec est ensuite ajouté à la dispersion colloïdale liquide du polymère conducteur et dispersé dans celle-ci.

13. Matériau composite comprenant un revêtement sur un substrat, ledit revêtement étant obtenu par le procédé de l'une quelconque des revendications 10 à 12.

14. Matériau composite de la revendication 13, le substrat étant sélectionné dans le groupe consistant en des métaux, semi-conducteurs, plastiques, céramiques et produits en bois.

15. Article électrique ou électronique comprenant le matériau composite selon la revendication 13 ou la revendication 14.

16. Article de la revendication 15, l'article étant sélectionné dans le groupe consistant en des conducteurs, dispositifs de stockage d'énergie, détecteurs, commutateurs, condenseurs, condensateurs et supercondensateurs, condensateurs à double couche et condensateurs redox.

17. Article de la revendication 16, ledit article étant un condensateur qui comprend un électrolyte et une paire d'électrodes entre lesquelles est disposé un séparateur, une au moins des électrodes comprenant le matériau composite selon la revendication 13 ou la revendication 14.

18. Condensateur de la revendication 17, dans lequel les deux électrodes comprennent le matériau composite selon la revendication 13 ou la revendication 14.

19. Condensateur de la revendication 17, dans lequel une électrode comprend le matériau composite selon la revendication 13 ou la revendication 14 et l'autre électrode est une électrode de condensateur conventionnelle.

20. Condensateur de la revendication 19, dans lequel l'autre électrode comprend un collecteur de courant revêtu d'une composition qui contient un polymère intrinsèquement conducteur mais pas de carbone.
